(19) Europäisches Patentamt
European Patent Office
Office européen des brevets

(11) **EP 2 450 715 A1**

(12) **EUROPÄISCHE PATENTANMELDUNG**

(43) Veröffentlichungstag:
**09.05.2012 Patentblatt 2012/19**

(51) Int Cl.:
***G01R 27/18*** *(2006.01)*    ***G01R 31/02*** *(2006.01)*

(21) Anmeldenummer: **10190359.9**

(22) Anmeldetag: **08.11.2010**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **ABB Technology AG**
**8050 Zürich (CH)**

(72) Erfinder:
• **Ackeret, Alexander**
  **5702 Niederlenz (CH)**
• **Lauwrens, Wynand M.**
  **5312 Döttingen (CH)**

(54) **Vorrichtung und Verfahren zum ermitteln des Erdwiderstands eines Gleichstromsystems**

(57)    Ein dem Gleichstrom eines Gleichstromsystems überlagerter Wechselstrom niederer Spannung wird dazu verwendet, den Erdwiderstand des Gleichstromsystems zu ermitteln.

Fig. 1

EP 2 450 715 A1

## Beschreibung

### Technisches Gebiet

Die Erfindung betrifft das Gebiet von nicht-geerdeten Gleichstromsystemen, beispielsweise Elektrolysesysteme. Insbesondere betrifft die Erfindung ein Verfahren zum Ermitteln des Erdwiderstands eines Gleichstromsystems, eine Vorrichtung zum Ermitteln des Erdwiderstands eines Gleichstromsystems und ein Gleichstromsystem.

### Stand der Technik

Bei der Elektrolyse von Aluminium werden riesige Anlagen eingesetzt, bei denen eine Vielzahl von Behältern zur Elektrolyse des Aluminiums elektrisch in Reihe geschaltet ist. An jedem der einzelnen Behälter liegt lediglich eine Spannung von wenigen Volt an. Da aber jeder Elektrolysebehälter einen sehr geringen Widerstand (weniger als 1 Ohm) aufweist, können den Behälter mehrere kA (Kiloampere) durchfließen. Durch die in Reihe geschaltete Kette von Elektrolysebehältern entsteht damit ein Gleichstromkreis, an dessen Endpolen eine Spannung von bis zu 2000 V anliegt und der von einem Strom von mehreren kA durchflossen werden kann.

Einerseits werden derartige Elektrolyseanlagen ohne Erdung bzw. mit nicht definiertem Potential zur Erde betrieben (sogenannte "floating systems"). Andererseits ist es auch möglich, diese Anlagen an einem bestimmten Punkt in der Anlage (zum Beispiel in der Mitte des Gleichstromkreises) über einen hohen Widerstand (beispielweise mehr als 10 kΩ) zu erden.

Um Isolationsfehler aufzuspüren, kann es bei derartigen Gleichspannungssystemen notwendig sein, den Widerstand zwischen dem Gleichspannungssystem und der Erde, den sogenannten Erdwiderstand, zu bestimmen. Bei einem nicht geerdeten Gleichstromsystem sollte dieser Erdwiderstand sehr hoch (beispielsweise über mehrere kΩ) sein. Bei einem Fehler, zum Beispiel wenn einer der Elektrolysebehälter ausläuft oder wenn durch Kriechströme eine nicht beabsichtigte Erdung des Gleichstromkreises erfolgt, sinkt der Erdwiderstand jedoch ab. Normalerweise wird der Erdwiderstand dadurch bestimmt, dass ein (hoher) Widerstand mit dem Gleichspannungssystem und der Erde verbunden wird und der durch den Widerstand fließende Strom gemessen wird. Da der angelegte Widerstand mit dem Erdwiderstand parallel geschaltet ist, kann durch diese Messung der Erdwiderstand bestimmt werden.

Hier kann jedoch das Problem entstehen, dass, wenn bereits eine (unbeabsichtigte) Erdung des Gleichstromsystems erfolgt ist, eine sehr hohe Spannung an dem angelegten Messwiderstand anliegt. Bei einem beispielsweise in der Mitte der Anlage geerdeten Gleichstromsystem wird deshalb zuerst die Verbindung zur Erde entfernt und danach erst der Messwiderstand mit dem Gleichspannungssystem an der gewünschten Stelle verbunden. Dies kann beispielsweise mit Hilfe eines mobilen Erdungsgeräts (ein sogenannter "earth trolley") erfolgen.

Bei nicht-geerdeten Gleichspannungssystemen ist gewöhnlich aus Sicherheitsgründen jede Verbindung zur Erde innerhalb des Gebäudes, in dem sich das System bzw. die Anlage befindet, zunächst untersagt. Die Messung des Erdwiderstands erfolgt dann durch manuelles Verbinden eines zum (eventuell vorhandenen) Erdwiderstand parallel geschalteten Messwiderstands. Dies kann beispielsweise durch Messung an der positiven Seite und an der negativen Seite des Gleichstromsystems erfolgen. Diese Vorgehensweise kann jedoch sehr gefährlich sein, da, wenn das Gleichstromsystem bereits durch eine nicht beabsichtigte Erdverbindung geerdet ist, eine sehr hohe Spannung am Messwiderstand anliegen kann.

Dies ist insbesondere dann der Fall, wenn das Gleichstromsystem eine niedrige Impedanz, das heißt einen niedrigen Innenwiderstand, aufweist, so wie es bei einer Elektrolyseanlage in der Regel der Fall ist.

### Darstellung der Erfindung

Es ist Aufgabe der Erfindung, ein sicheres Verfahren und eine sichere Vorrichtung zur Ermittlung des Erdwiderstands eines Gleichstromsystems bereitzustellen. Diese Aufgabe wird durch den Gegenstand der unabhängigen Ansprüche gelöst. Weitere Ausführungsformen der Erfindung ergeben sich aus den abhängigen Ansprüchen und aus der folgenden Beschreibung.

Ein erster Aspekt der Erfindung betrifft ein Verfahren zum Ermitteln des Erdwiderstands eines Gleichstromsystems. Das Gleichstromsystem kann dabei nicht-geerdet sein bzw. ein nicht definiertes Potential zur Erde aufweisen. Dies ist so zu verstehen, dass das Gleichstromsystem im Normalbetrieb, das heißt im fehlerlosen Betrieb, nicht geerdet bzw. erdfrei ist. Mit anderen Worten soll der Erdwiderstand bzw. der Widerstand zwischen dem Neutralpunkt des Systems und der Umgebung des Systems größer als einige kΩ sein.

Beispielsweise kann das Gleichstromsystem eine Elektrolyseanlage sein. Es ist aber auch möglich, das Verfahren bei anderen Gleichstromsystemen anzuwenden, wie beispielsweise mit Gleichspannung betriebenen Untergrundbahnen.

Denkbar sind dabei Systeme, bei denen bei einer relativ hohen Spannung ein relativ geringer Innenwiderstand vorhanden ist. Beispielsweise kann das Gleichstromsystem einen Spannungsbereich von bis zu 2500 V aufweisen und/oder von einem Strom von mehreren 100 A oder mehreren kA durchflossen sein.

Gemäß einer Ausführungsform der Erfindung umfasst das Verfahren die Schritte von: Erzeugen eines Wechselstromsignals; Überlagern eines im Gleichstromsystem vorliegenden Gleichstroms mit dem Wechselstromsignal; Ermitteln der Spannung und der Stromstärke des Wechselstromsignals; Ermitteln des Erdwiderstands des Gleichstromsystems aus der Spannung und der Stromstärke.

Das Verfahren kann von einer Vorrichtung zum Ermitteln des Erdwiderstands ausgeführt werden, die über eine Kopplungsanordnung, beispielsweise einen oder mehrere Entkopplungskondensatoren und/oder einen Transformator, mit dem Gleichstromsystem elektrisch verbunden ist.

Mit anderen Worten kann die Vorrichtung ein Niederspannungs-Wechselstromsystem umfassen, mit dem ein Wechselstrom in das Gleichstromsystem eingekoppelt und dort mit dem Gleichstrom überlagert werden kann. Überlagern kann dabei zum Gleichstrom hinzufügen bzw. zum Gleichstrom addieren bedeuten. Anschließend können im vom Gleichstromsystem entkoppelten Wechselstromsystem die Stromstärke und die Spannung des Wechselstromsignals gemessen werden und daraus der Erdwiderstand des Gleichstromsystems berechnet werden.

Kurz gefasst kann ein dem Gleichstrom überlagerter Wechselstrom niederer Spannung dazu verwendet werden, den Erdwiderstand eines Gleichstromsystems zu ermitteln.

Auf diese Weise kann der Erdwiderstand (und auch, wie weiter unten beschrieben, die Erdkapazität) eines Gleichstromsystems ermittelt werden, ohne dass das Gleichstromsystem geerdet werden muss. Lediglich das Wechselstromsystem, das vom Gleichstromsystem entkoppelt sein kann, ist über einen Messwiderstand geerdet.

Mit einer derartigen Vorrichtung kann der Erdwiderstand eines nicht-geerdeten Hochspannungs-Gleichstromsystems mit einem Testsignal (dem Wechselstromsignal) ermittelt werden, das für eine versehentliche Berührung durch einen Menschen ungefährlich ist. Beispielsweise kann die Spannung des Wechselstromsignals weniger als 150 V, beispielsweise 100 V oder 50 V, betragen.

Beim Durchführen des Verfahrens ist keine Verbindung zur Erde notwendig, das Gleichstromsystem kann auch während der Messung erdfrei bleiben. Darüber hinaus ist eine Ermittlung bzw. Messung des Erdwiderstands für Systeme zwischen 20 bis 2500 Ω Gleichstromwiderstand möglich. Gleiches gilt für die Messung bzw. die Ermittlung der Erdkapazität. Dabei kann das Verfahren auch bei (relativ) hohen Gleichspannungen bis beispielsweise 2500 V durchgeführt werden.

Mit dem erfindungsgemäßen Verfahren ist eine kontinuierliche Überwachung und Messung des Erdwiderstands möglich. Das Verfahren bietet ein hohes Niveau von Sicherheit einerseits für Menschen, die die Messungen durchführen, und andererseits auch für die Gerätschaft, mit der das Verfahren durchgeführt wird.

Gemäß einer Ausführungsform der Erfindung wird der Erdwiderstand mit Hilfe der Formel

$$R = \frac{U}{I \cos \varphi} \qquad (1)$$

berechnet. R ist dabei der Erdwiderstand, U die maximale Amplitude der Spannung, I die maximale Amplitude der Stromstärke und φ die Phasenverschiebung zwischen Spannung und Stromstärke. Die eben genannte Formel kann als Ohmsches Gesetz für Wechselströme aufgefasst werden.

Gemäß einer Ausführungsform ist das Wechselstromsignal ein Sinussignal und/oder weist eine (niedrige) Frequenz von 3 bis 10 Hz auf. Mit anderen Worten kann das Test- bzw. Wechselstromsignal ein Niederfrequenzsignal von 3 bis 10 Hz in der Form einer Sinuswelle sein, wobei die Amplitude des Wechselstromsignals derart eingestellt werden kann, dass ein für Menschen sicheres Signal zur Erde bereitgestellt ist. Auf diese Weise kann das Signal in das Gleichspannungssystem mittels eines Entkopplungskondensators eingespeist werden und Messungen können mittels des Entkopplungskondensators auch auf der Seite des Wechselstromsystems bei niedriger Spannung durchgeführt werden.

Gemäß einer Ausführungsform umfasst das Verfahren weiter den Schritt von: kontinuierliches Ermitteln von Spannungswerten und Stromstärkewerten des Wechselstromsignals. Mit kontinuierlichem Ermitteln kann dabei das Ermitteln der Werte in kurzen aufeinander abfolgenden Zeitperioden gemeint sein. Die Zeitperioden können dabei so gewählt werden, dass das Wechselstromsignal abgetastet werden kann. Beispielsweise könnten die Werte alle 10 ms ermittelt werden, wenn das Wechselstromsignal eine Frequenz von weniger als 10 Hz hat. Grundsätzlich kann dadurch der zeitliche Verlauf von Spannung und Stromstärke mittels diskreten Messungen ermittelt werden.

Das kontinuierliche Ermitteln kann auch intervallweise durchgeführt werden, das heißt dass während eines ersten zeitlichen Intervalls Spannung und Stromstärke kontinuierlich ermittelt werden und während eines zweiten Intervalls, das auf das erste zeitliche Intervall folgt, keine Ermittlung von Spannung und Stromstärke erfolgt. Beispielsweise könnte auf diese Weise der Erdwiderstand alle 10 s durch das Verfahren ermittelt werden.

Auf diese Weise ist es möglich, dass der Erdwiderstand in regelmäßigen Abständen ermittelt wird, so dass der Erdwiderstand auch selbstständig durch die Vorrichtung mittels des Verfahrens überwacht werden kann. Im Fehlerfall, das heißt wenn mittels des Verfahrens oder mittels der Vorrichtung festgestellt wird, dass der Erdwiderstand unter einem vordefinierten Wert (beispielsweise 1 kΩ) sinkt, eine Warnmeldung ausgegeben werden oder eine Abschaltung des Gleichstromsystems angestoßen werden.

Gemäß einer Ausführungsform der Erfindung umfasst das Verfahren weiter den Schritt von: Ermitteln der maximalen Amplitude der Spannung des Wechselstromsignals aus den Spannungswerten und der maximalen Amplitude der Stromstärke des Wechselstromsignals aus den Stromstärkewerten. Beispielsweise kann als maximaler Amplitudenwert einfach das Maximum aller Messwerte während des letzten Messintervalls genommen werden.

Gemäß einer Ausführungsform der Erfindung umfasst das Verfahren weiter den Schritt von: Ermitteln der Phasenverschiebung zwischen Spannung und Stromstärke des Wechselstromsignals aus den Spannungswerten und den Stromstärkewerten. Die Phasenverschiebung bestimmt sich bei periodischer Spannung und Stromstärke daraus, wie die beiden Kurven gegenüber einander zeitlich verschoben sind.

Gemäß einer Ausführungsform der Erfindung wird die Phasenverschiebung aus dem Nulldurchgang der Spannung und dem Nulldurchgang der Stromstärke ermittelt. Beispielsweise können aus den ermittelten Spannungswerten und Stromstärkewerten die Werte ausgewählt werden, die jeweils über und unterhalb des Nulldurchgangs liegen, das heißt zwei Werte, von denen einer größer und der andere kleiner 0 ist. Durch Interpolation kann dann der Nulldurchgang des jeweiligen Signals bestimmt werden. Die Phasenverschiebung ergibt sich dann als Differenz der beiden Nulldurchgänge, die jeweils benachbarter Maxima bzw. benachbarter Minima der Spannung und der Stromstärke folgen.

Gemäß einer Ausführungsform der Erfindung umfasst das Verfahren weiter den Schritt von: Ermitteln der Erdkapazität aus der Spannung, der Stromstärke, dem Erdwiderstand und der Frequenz des Wechselstromsignals. Die Erdkapazität kann dabei die Kapazität zwischen dem Gleichstromsystem und der Erde sein und kann die Eigenkapazität zwischen dem Gleichstromsystem und der Erde und die Überspannungsschutzkapazitäten, die beispielsweise vor dem Umrichter angeordnet sind und das System vor Überspannungen schützen, umfassen. Da es möglich ist, dass das Wechselstromsignal im Gegensatz zu einem Gleichstromsignal durch den Umrichter hindurchdringen kann, kann mittels des Ermittelns der Erdkapazität auch überprüft werden, ob die Überspannungsschutzkondensatoren defekt sind. In diesem Fall ändert sich nämlich die ansonsten relativ konstante Erdkapazität des Gleichstromsystems.

Gemäß einer Ausführungsform der Erfindung wird die Erdkapazität mit Hilfe der Formel

$$C = \sqrt{\left(\frac{I}{\omega U}\right)^2 - \left(\frac{1}{\omega R}\right)^2} \qquad (2)$$

berechnet. Dabei ist C die Erdkapazität, R der Erdwiderstand, U die maximale Amplitude der Spannung, I die maximale Amplitude der Stromstärke und φ die Frequenz

des Wechselstromsignals.

Gemäß einer Ausführungsform der Erfindung erfolgt das Überlagern des Wechselstromsignals dadurch, dass das Wechselstromsignal über wenigstens einen Entkopplungskondensator in das Gleichstromsystem ein- bzw. ausgekoppelt wird. Dabei kann der Entkopplungskondensator zwischen die Vorrichtung zum Erzeugen der Wechselspannung und das Gleichstromsystem geschaltet sein. Auch kann der Entkopplungskondensator ein Hochspannungskondensator sein, so dass auch ein Gleichstromsystem mit einer hohen Gleichspannung wirksam von der Vorrichtung zum Ermitteln des Erdwiderstands (galvanisch) entkoppelt bzw. davon getrennt werden kann.

Gemäß einer Ausführungsform der Erfindung umfasst das Verfahren weiter den Schritt von: Einkoppeln des Spannungssignals über einen Transformator. Mit dem Transformator kein einerseits das Wechselstromsignal bzw. das Wechselspannungssystem vom Gleichstromsystem entkoppelt werden. Andererseits kann das Wechselstromsignal von einem einfach aufgebauten Niederspannungsgenerator erzeugt werden und dann vom Transformator auf die gewünschte Höhe hochtransformiert werden, beispielsweise auf eine maximale Amplitude von 100 V.

Gemäß einer Ausführungsform der Erfindung beträgt die Amplitude des Wechselstromsignals weniger als 150 V (beispielsweise 100 V oder 50 V). Auf diese Weise kann das Testsignal bzw. das Wechselstromsignal erzeugt werden, das für einen Menschen (relativ) ungefährlich ist.

Ein weiterer Aspekt der Erfindung betrifft eine Vorrichtung zum Ermitteln des Erdwiderstands eines Gleichstromsystems.

Gemäß einer Ausführungsform der Erfindung umfasst die Vorrichtung einen Wechselstromgenerator zum Erzeugen eines Wechselstromsignals. Der Wechselspannungsgenerator kann dabei einen Frequenzgenerator umfassen, der das Wechselstromsignal beispielsweise in der Form einer Sinuswelle erzeugt. Zum Beispiel kann der Frequenzgenerator und auch der Wechselspannungsgenerator ein PLC (Programmable Logic Controller) sein. Darüber hinaus kann der Wechselspannungsgenerator einen Leistungsverstärker umfassen, der die Stromstärke des Wechselstromsignals erhöht.

Gemäß einer Ausführungsform der Erfindung umfasst die Vorrichtung eine Kopplungsanordnung zum Ein- und Auskoppeln des Wechselstromsignals in einen Gleichstromkreis des Gleichstromsystems. Wie bereits gesagt, kann die Kopplungsanordnung dazu beispielsweise einen Transformator umfassen, dessen Primärwicklung mit dem Wechselstromgenerator, beispielsweise dem Leistungsverstärker, und dessen Sekundärwicklung mit einem Entkopplungskondensator verbunden ist. Die Kopplungsanordnung kann wenigstens einen Entkopplungskondensator umfassen, der zwischen dem Gleichspannungsstromkreis und dem Wechselspannungsgenerator geschaltet ist. Mit dem Entkopplungskondensator kann das Wechselstromsignal einerseits in das Gleichstromsystem eingekoppelt bzw. mit dem Gleichstrom aus dem Gleichstromsystem überlagert werden. Andererseits kann auch das phasenverschobene Wechselstromsignal wieder über dem oder die Entkopplungskondensatoren aus dem Gleichstromsystem entnommen bzw. ausgekoppelt werden.

Dabei ist es möglich, dass die Kopplungsanordnung einen ersten Entkopplungskondensator und einen zweiten Entkopplungskondensator umfasst, wobei der erste Entkopplungskondensator zwischen den Wechselspannungsgenerator (bzw. den Transformator) und einen Pol des Gleichstromsystems geschaltet ist und wobei der zweite Entkopplungskondensator zwischen den Pol und eine Erdung der Vorrichtung geschaltet ist. Der Pol des Gleichstromsystems kann entweder der negative oder der positive Pol des Gleichstromsystems sein, das heißt beispielsweise die Stelle, an dem eine maximale bzw. minimale Spannung im Gleichstromsystem vorhanden ist. Im Allgemeinen kann der Pol aber jede beliebige Stelle des Gleichstromsystems sein, an die die Vorrichtung zum Ermitteln des Erdwiderstands angeschlossen werden kann.

Gemäß einer Ausführungsform der Erfindung umfasst die Vorrichtung zum Ermitteln des Erdwiderstands eine Messanordnung zum Ermitteln der Stromstärke und der Spannung des Wechselstromsignals. Dabei kann die Messanordnung einen ersten Sensor umfassen, der dazu ausgeführt ist, die Spannung des Wechselstromsignals zu ermitteln. Der Sensor kann zwischen die Erde und den zweiten Entkopplungskondensator geschaltet sein. Die Messanordnung kann weiter einen zweiten Sensor umfassen, der dazu ausgeführt ist, die Stromstärke des Wechselstromsignals zu ermitteln. Dabei kann der zweite Sensor zwischen den Frequenzgenerator (bzw. den Transformator) und die Erde geschaltet sein.

Gemäß einer Ausführungsform der Erfindung umfasst die Vorrichtung zum Ermitteln des Erdwiderstands eine Verarbeitungseinheit, die dazu ausgeführt ist, einen Erdwiderstand des Gleichstromsystems aus der Stromstärke und der Spannung des Wechselstromsignals zu ermitteln.

Ein weiterer Aspekt der Erfindung betrifft ein Gleichstromsystem, insbesondere Elektrolysesystem, mit einer Vorrichtung zum Ermitteln des Erdwiderstands, so wie sie obenstehend und untenstehend beschrieben ist. Das Gleichstromsystem kann dabei ein Hochspannungssystem, das heißt ein System, das Potentialdifferenzen über 1000 V aufweist, sein. Auch ist es möglich, dass das Gleichstromsystem einen niedrigen Innenwiderstand aufweist, beispielsweise von weniger als 2500 $\Omega$.

Ein weiterer Aspekt der Erfindung betrifft ein Programmelement, beispielsweise ein Programm bzw. Computerprogramm, das, wenn es auf wenigstens einem Prozessor ausgeführt wird, den Prozessor dazu anleitet, die Schritte des Verfahrens, so wie es obenstehend und untenstehend beschrieben ist, durchzuführen. Der Prozessor kann dabei Bestandteil des PLC sein.

Dabei ist zu verstehen, dass das beschriebene Verfahren als programmiertes Softwaremodul oder als Funktionen eines größeren Programms implementiert sein kann. Es ist jedoch auch möglich, dass einzelne oder alle Verfahrensschritte teilweise oder vollständig mittels Hardware implementiert sind.

Ein weiterer Aspekt der Erfindung betrifft ein computerlesbares Medium, auf dem ein derartiges Programmelement gespeichert ist. Ein computerlesbares Medium kann dabei eine Diskette, eine Harddisk, ein USB-Speichergerät, ein RAM, ein ROM, ein EPROM sein. Ein computerlesbares Medium kann auch ein Datenkommunikationsnetzwerk, wie beispielsweise das Internet, das den Download eines Programmcodes ermöglicht, sein.

Es ist zu verstehen, dass Merkmale des Verfahrens so wie obenstehend und untenstehend beschrieben auch Merkmale der Vorrichtung sein können und umgekehrt.

Falls technisch möglich, aber nicht explizit genannt, sind auch Kombinationen von Ausführungsformen so wie obenstehend und untenstehend beschrieben auch Ausführungsformen des Verfahrens und der Vorrichtung.

## Kurze Beschreibung der Zeichnungen

Im Folgenden werden Ausführungsbeispiele der Erfindung mit Bezug auf die beiliegenden Figuren detailliert beschrieben.

Fig. 1 zeigt ein Gleichstromsystem gemäß einer Ausführungsform der Erfindung.
Fig. 2 zeigt eine Kopplungsanordnung gemäß einer weiteren Ausführungsform der Erfindung.
Fig. 3 zeigt ein Flussdiagramm für ein Verfahren zum Ermitteln des Erdwiderstands gemäß einer Ausführungsform der Erfindung.
Fig. 4 zeigt ein Diagramm, mit dem die Berechnung des Erdwiderstands gemäß einer Ausführungsform der Erfindung erläutert wird.
Fig. 5 zeigt ein Flussdiagramm für ein Verfahren zum Berechnen des Erdwiderstands gemäß einer Ausführungsform der Erfindung.

Die in den Figuren verwendeten Bezugszeichen und ihre Bedeutung sind in zusammenfassender Form in der Liste der Bezugszeichen aufgeführt. Grundsätzlich sind identische oder ähnliche Teile mit den gleichen Bezugszeichen versehen.

## Wege zur Ausführung der Erfindung

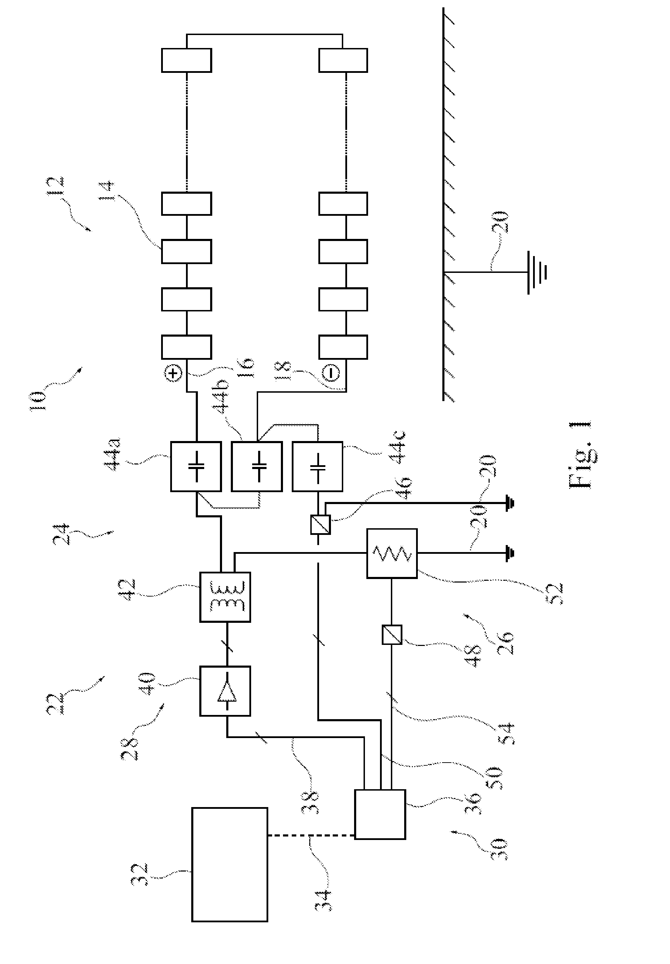

Fig. 1 zeigt ein Gleichstromsystem 10, das beispielsweise, wie hier dargestellt, ein Elektrolysesystem 10 ist. Das Gleichstromsystem 10 umfasst einen Gleichstromkreis 12, der hier aus einer Anordnung von in Reihe geschalteter Elektrolysebehälter 14 besteht. Dadurch, dass jeder der Elektrolysebehälter 14 lediglich einen niedrigen Widerstand von beispielsweise weniger als 1 Ω aufweist, weist auch der Gleichstromkreis 12 zwischen seinem positiven Pol 16 und seinem negativen Pol 18 einen niedrigen Widerstand auf. Bei dem Elektrolysesystem 10 liegt zwischen den Polen 16, 18 eine Spannung von etwa 2000 V an, so dass durch den Gleichstromkreis 12 ein Gleichstrom von einer Stromstärke mit mehreren 100 A fließen kann. Wie in der Fig. 1 dargestellt, ist das Gleichstromsystem 10 nicht mit der Erde 20 verbunden, sondern weist kein definiertes Potential zur Erde 20 auf. Im linken Teil der Fig. 1 ist eine Vorrichtung zum Ermitteln des Erdwiderstands 22 dargestellt, die über eine Kopplungsanordnung 24 mit dem Gleichstromsystem 10 verbunden ist.

Im vorliegenden Ausführungsbeispiel ist ein Feld-PLC 32 Teil des Wechselstromgenerators 28, der über eine faseroptische Verbindung 34 mit einem schnellen Eingabe/Ausgabe-Gerät 36 verbunden ist. Das Eingabe/Ausgabe-Gerät 36 und der Feld-PLC 32 bilden dabei eine Verarbeitungseinheit 30, die auch einen Prozessor aufweisen kann, der die beschriebenen Berechnungen durchführt.

Der Feld-PLC 32 weist dabei über die faseroptische Verbindung 34 das schnelle Eingabe/Ausgabe-Gerät 36 an, ein sinusförmiges Wechselstromsignal auf der Leitung 38 zu erzeugen. Auf der Leitung 38 wird dabei ein analoges Ausgabesignal erzeugt, das eine maximale Amplitude von 7 V bei einer Frequenz von 5 Hz aufweist. Die Leitung 38 ist mit einem Verstärker 40 verbunden, der dazu ausgeführt ist, ein Eingabesignal mit einer maximalen Amplitude von 10 V auf ein Ausgabesignal mit einer maximalen Amplitude von 10 V und einer maximalen Stromstärke von 1,5 A zu verstärken. Dem Verstärker 40 ist ein isolierter Transformator 42 nachgeschaltet, mit beispielsweise einer maximalen Durchschlagspannung von 10 kV. Der Transformator 42 verstärkt Die Spannung des Wechselstromsignals dabei um den Faktor 10, beispielsweise von 10 V auf 100 V. Das dem Transformator 42 verlassende Wechselstromsignal weist dabei eine Wechselspannung von durchschnittliche 50 V und eine Stromstärke von durchschnittlich 25 mA auf.

Der Transformator 42 bzw. die Sekundärwicklung des Transformators 42 ist mit der Kopplungsanordnung 24 verbunden, die mehrere Entkopplungskondensatoren 44a, 44b und 44c aufweist, die in Reihe geschaltet sind. Dabei ist der erste Entkopplungskondensator 44a an einer Seite mit dem positiven Pol 16 des Gleichstromsystems 10 verbunden und die andere Seite des Entkopplungskondensators 44a ist mit der Sekundärwicklung des Transformators 42 verbunden. Mit dieser Seite des Entkopplungskondensators 44a ist auch der zweite Entkopplungskondensator 44b verbunden, der auf seiner anderen Seite wiederum mit dem negativen Pol 18 des Gleichstromsystems 10 und einem weiteren, dritten Entkopplungskondensator 44c verbunden ist.

Die Entkopplungskondensatoren 44a, 44b und 44c können dabei so gewählt werden, dass die Gleichspannung aus dem Gleichstromsystem 10 gegenüber der Vorrichtung 22 abgeschirmt wird. Beispielsweise können dazu Hochspannungskondensatoren 44a, 44b und 44c verwendet werden, die eine galvanische Isolierung von über 2500 V bereitstellen.

Ist das Gleichstromsystem im normalen Betriebsfall nicht-geerdet, ist ein hoher (bzw. unendlicher) Erdwiderstand vorhanden und das Gleichstromsignal aus dem Transformator 42 erfährt keine Phasenverschiebung. Mit anderen Worten sind die Spannung und die Stromstärke des Wechselstromsignals in Phase. Ist das Gleichstromsystem jedoch geerdet, beispielsweise durch einen Fehlerfall, so führt dies dazu, dass die Spannung und die Stromstärke abhängig von der Größe des Erdwiderstands gegenüber einander verschoben sind. Der Zusammenhang dieser Größen ist aus der Formel (1) ableitbar. Sind die eben genannten Größen bekannt, so kann auch die Erdkapazität des Gleichstromsystems 10 bestimmt werden, so wie es in Formel (2) angegeben ist.

Zur Ermittlung dieser Größen weist die Messanordnung 26 einen Spannungssensor 46 und einen Stromsensor 48 auf. Der Spannungssensor 46 ist dabei zwischen den dritten Kondensator 44c und die Erde 20 geschaltet. Bei dem Spannungssensor 46 kann es sich um einen Spannungs-Messwandler 46 handeln, der ein Eingangssignal zwischen -100 V und +100 V in ein Ausgabesignal zwischen -20 mA und 20 mA umwandelt. Das Ausgabesignal des Messwandlers bzw. Spannungssensors 46 wird dann über die Leitung 50 an das Ein-/Ausgabe-Gerät 36 übermittelt, das es beispielsweise in digitalisierter Form über die faseroptische Verbindung 34 an den Feld-PLC 32 weiterleiten kann. Der Stromstärkesensor 48 kann ein Spannungs-Messwandler 48 sein, der eine Messspannung über einen Messwiderstand 52 von beispielsweise 1,414 Ohm abgreift. Dabei kann der Spannungs-Messwandler 48 derart ausgeführt sein, dass er eine Eingangsspannung zwischen -60 mV und +60 mV in ein Ausgangssignal zwischen -20 mA und +20 mA umwandelt, das über eine Leitung 54 an das Ein-/Ausgabe-Gerät 36 übermittelt wird. Auch der gemessene Stromstärkewert kann über die faseroptische Verbindung 34 an den Feld-PLC 32 weitergeleitet werden.

Bei der in der Fig. 1 gezeigten Ausführungsform einer Vorrichtung 22 zum Ermitteln des Erdwiderstands ist die Vorrichtung über die Entkopplungskondensatoren 44a, 44b und 44c direkt mit beiden Polen 16, 18 des Gleichstromsystems 10 verbunden.

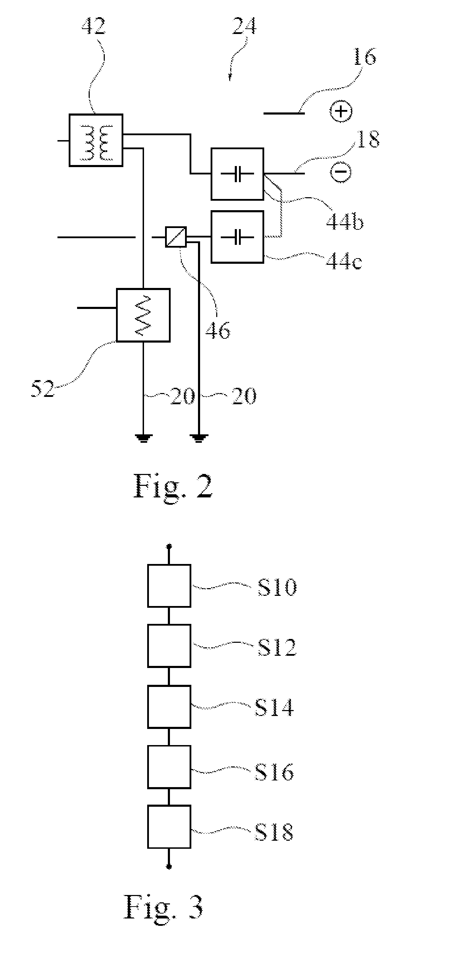

Im Gegensatz dazu zeigt die Fig. 2 einen Teil einer Vorrichtung 22 mit einer Kopplungsanordnung 24, die lediglich mit einem Pol 18 des Gleichstromsystems 10 verbunden ist. In der Fig. 2 ist die Vorrichtung 22 an den negativen Pol 18 des Gleichstromsystems 10 gekoppelt, es ist jedoch möglich, die Kopplung an jedem beliebigen anderen Punkt des Gleichstromsystems 10 mittels der Kopplungsanordnung 24 durchzuführen. Dazu weist die Kopplungsanordnung 24 zwei in Reihe geschaltete Entkopplungskondensatoren 44b und 44c auf, zwischen die der Pol 18 geschaltet ist. Auf ihrer anderen Seite sind die Kopplungskondensatoren 44b, 44c jeweils mit der Sekundärwicklung des Transformators 42 bzw. mit dem Spannungssensor 46 verbunden.

Auch wenn der positive Pol 16 des Gleichstromsystems 10, so wie in der Fig. 2 dargestellt, nicht mit der Vorrichtung 22 verbunden ist, so ist er, genauso wie der negative Pol 18, mit einem Umrichter oder einer ähnlich gearteten Vorrichtung verbunden, die die Spannung für das Gleichstromsystem 10 erzeugt.

In der Fig. 3 ist ein Flussdiagramm für ein Verfahren zum Ermitteln des Erdwiderstands des Gleichstromsystems 10 mit der Vorrichtung 22 dargestellt.

Im Schritt S10 wird das Wechselstromsignal mit dem Wechselstromgenerator 28 erzeugt und verstärkt. Dazu wird es vom Feld-PLC 32 generiert, von dem Ein-/ Ausgabe-Gerät 36 in ein Stromsignal umgewandelt, das vom Verstärker 40 verstärkt und vom Transformator 42 auf die gewünschte Signalspannung transformiert wird.

Im Schritt S12 wird das Wechselstromsignal in den Gleichstromkreis 12 des Gleichstromsystems 10 eingekoppelt und dabei dem Gleichstrom im Gleichstromsystem 10 überlagert. Dies erfolgt mit der Kopplungsanordnung 24, die einen oder mehrere Entkopplungskondensatoren 24a, 24b, 24c umfassen kann.

In einem Schritt S16 erfolgt die Messung der Spannung und der Stromstärke des, falls ein Erdwiderstand vorhanden ist, phasenverschobenen Wechselstromsignals. Dazu wird die Stromstärke mittels Spannungsmessung über einen Messwiderstand 42 ermittelt. Die Messung der Spannung des Wechselstromsignals erfolgt über den Spannungssensor 46.

In einem Schritt S18 werden die ermittelte Stromstärke und die ermittelte Spannung von dem Ein-/ Ausgabe-Gerät 36 empfangen, an den Feld-PLC 32 weitergeleitet und dort mit den angegebenen Formeln (1) und (2) der Erdwiderstand und die Erdkapazität des Gleichstromsystems 10 berechnet.

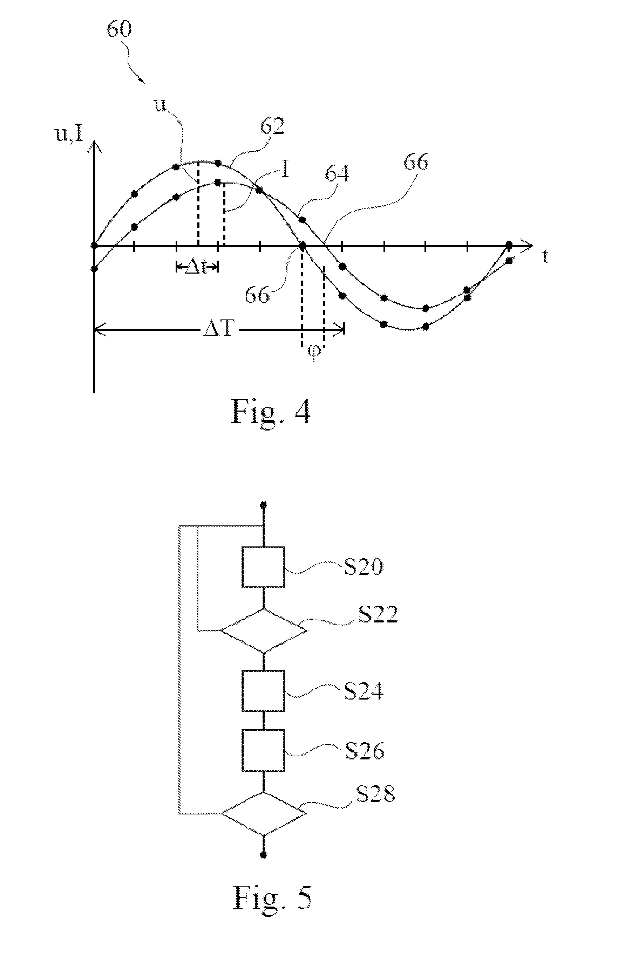

Die Fig. 4 zeigt ein Diagramm, mit dem die Berechnung des Erdwiderstands und der Erdkapazität weiter erläutert wird. In dem Diagramm ist das Wechselstromsignal 60 gegenüber der Zeit t aufgetragen. Das Wechselstromsignal umfasst dabei einen sinusförmigen Spannungsverlauf 62 und einen sinusförmigen Stromstärkeverlauf 64. Wie aus dem Diagramm ersichtlich ist, weist das Wechselstromsignal eine maximale Spannungsamplitude U und eine maximale Stromstärkeamplitude I auf. Auch sind die beiden Sinuskurven 62 und 64 gegenüber einander phasenverschoben. Die Phasenverschiebung φ kann dabei mittels der Nulldurchgänge 66 der beiden Kurven 62, 64 bestimmt werden.

Wie auch weiter in der Fig. 4 gezeigt ist, werden die Spannung 62 und die Stromstärke 64 des Wechselstromsignals 60 nicht ununterbrochen, sondern in diskreten Zeitschritten mit dem Abstand Δt gemessen bzw. abgetastet.

Dazu ist in Fig. 5 ein Flussdiagramm dargestellt, das mit Bezug auf Fig. 4 erläutert wird. Erhält die Vorrichtung 22 den Befehl, den Erdwiderstand zu ermitteln, beginnt sie in regelmäßigen Abständen Δt die Spannung und die Stromstärke des Wechselstromsignals 60 zu ermitteln. Dazu misst sie in einem Schritt S20 die Spannung am Spannungssensor 46 und die Stromstärke am Stromstärkesensor 48. Im Schritt S22 wird dann ermittelt, ob eine genügende Menge an einzelnen Messwerten vorliegt, um die Maximalspannung U, die Maximalstromstärke I und die Phasenverschiebung φ zu ermitteln, oder ob weitere Messwerte aufgezeichnet werden sollen. Im letzten Fall wird gewartet, bis das Zeitintervall Δt vergangen ist und im Schritt S20 ein weiteres Paar von Messwerten von Spannung und Stromstärke aufgezeichnet.

Die Anzahl der notwendigen Messwerte, um die oben genannten Größen zu bestimmen, hängt hauptsächlich von der Frequenz des Wechselstromsignals ab. Wie aus der Fig. 4 ersichtlich ist, ist eine Möglichkeit, so viele Messungen von Messwerten durchzuführen, bis eine Zeit ΔT verstrichen ist, die etwas länger ist als die Zeit einer Halbschwingung von Spannung oder Stromstärke.

Sind genügend Einzelmesswerte vorhanden, wird in einem Schritt S24 der Erdwiderstand R und die Erdkapazität C gemäß den Formeln (1) und (2) bestimmt. Dazu wird die maximale Amplitude U der Spannung 62 und die maximale Amplitude I der Stromstärke 64 ermittelt. Dies kann beispielsweise dadurch bewerkstelligt werden, dass einfach das Maximum der einzelnen aufgenommenen Messwerte bestimmt wird. Alternativ dazu kann auch der Kurvenverlauf zwischen den Messwerten interpoliert werden. Die Phasenverschiebung φ bestimmt sich aus den Nulldurchgängen der Kurven 62 und 64, die auch durch Interpolation der aufgenommenen Messwerte bestimmt werden können. Beispielsweise können, falls keiner der Messwerte den Wert 0 aufweist, die Messwerte links und rechts vom Nulldurchgang, das heißt benachbarte Messwerte mit unterschiedlichen Vorzeichen durch eine Gerade verbunden werden und der Schnittpunkt dieser Gerade mit der Nulllinie als Nulldurchgang genommen werden.

Die berechneten Werte können dann in einem Schritt S26 entweder auf einer Anzeige ausgegeben oder an weitere Einrichtungen versendet werden, die dann beispielsweise den Erdwiderstand des Gleichstromsystems 10 überwachen können. In einem Schritt S28 wird entschieden, ob zu einem späteren Zeitpunkt eine weitere Ermittlung des Erdwiderstands bzw. der Erdkapazität durchgeführt werden soll (in diesem Fall wird dann das Verstreichen einer vordefinierten Zeitperiode abgewartet) oder das Ermitteln der Werte wird beendet. In diesem Fall kann auch das Erzeugen des Wechselstromsignals abgebrochen werden.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

**Bezugszeichenliste**

| | |
|---|---|
| 10 | Gleichstromsystem |
| 12 | Gleichstromkreis |
| 14 | Elektrolysebehälter |
| 16 | positiver Pol |
| 18 | negativer Pol |
| 20 | Erde |
| 22 | Vorrichtung zum Ermitteln des Erdwiderstands |
| 24 | Kopplungsanordnung |
| 26 | Messanordnung |
| 28 | Wechselstromgenerator |
| 30 | Verarbeitungseinheit |
| 32 | Feld-PLC |
| 34 | faseroptische Verbindung |
| 36 | schnelles Eingabe/Ausgabe-Gerät |
| 38 | Leitung |
| 40 | Verstärker |
| 42 | Transformator |
| 44a | Kondensator |
| 44b | Kondensator |
| 44c | Kondensator |
| 46 | Spannungssensor |
| 48 | Stromstärkesensor |
| 50 | Leitung |
| 52 | Messwiderstand |
| 54 | Leitung |
| 60 | Wechselstromsignal |
| 62 | Spannung |
| 64 | Stromstärke |
| 66 | Nulldurchgang |

**Patentansprüche**

1. Verfahren zum Ermitteln des Erdwiderstands eines Gleichstromsystems (10), welches ein nicht definiertes Potential zur Erde aufweist, das Verfahren umfassend:

   Erzeugen eines Wechselstromsignals (60);
   Überlagern eines im Gleichstromsystem (10) vorliegenden Gleichstroms mit dem Wechselstromsignal (60);
   Ermitteln der Spannung (62) und der Stromstärke (64) des Wechselstromsignals (60);
   Ermitteln des Erdwiderstands des Gleichstromsystems (10) aus der Spannung (62) und der Stromstärke (64).

2. Verfahren nach Anspruch 1, weiter umfassend:

   Kontinuierliches Ermitteln von Spannungswerten und Stromstärkewerten des Wechselstromsignals (60);
   Ermitteln der maximalen Amplitude (U) der Spannung (62) des Wechselstromsignals aus den Spannungswerten und Ermitteln der maximalen Amplitude (I) der Stromstärke (64) des Wechselstromsignals aus den Stromstärkewerten;
   Ermitteln der Phasenverschiebung (φ) zwischen Spannung (62) und Stromstärke (64) des Wechselstromsignals (60) aus den Spannungswerten und den Stromstärkewerten;
   Ermitteln des Erdwiderstands aus der maximalen Amplitude (U) der Spannung (62),
   der maximalen Amplitude (I) der Stromstärke (64) und der Phasenverschiebung (φ).

3. Verfahren nach Anspruch 1 oder 2, wobei der Erdwiderstand mithilfe der Formel $R = \dfrac{U}{I\cos\varphi}$ berechnet wird, wobei R der Erdwiderstand, U die maximale Amplitude der Spannung, I die maximale Amplitude der Stromstärke und φ die Phasenverschiebung zwischen Spannung und Stromstärke ist.

**4.** Verfahren nach Anspruch 2 oder 3, wobei die Phasenverschiebung ($\varphi$) aus dem Nulldurchgang (66) der Spannung (62) und dem Nulldurchgang (66) der Stromstärke (64) ermittelt wird.

**5.** Verfahren nach einem der vorhergehenden Ansprüche, weiter umfassend:

Ermitteln der Erdkapazität aus der Spannung, der Stromstärke, dem Erdwiderstand und der Frequenz des Wechselstromsignals.

**6.** Verfahren nach Anspruch 5, wobei die Erdkapazität mithilfe der Formel $C = \sqrt{\left(\dfrac{I}{\omega U}\right)^2 - \left(\dfrac{1}{\omega R}\right)^2}$ berechnet wird, wobei C die Erdkapazität, R der Erdwiderstand, U die maximale Amplitude der Spannung, I die maximale Amplitude der Stromstärke und w die Frequenz des Wechselstromsignals ist.

**7.** Verfahren nach einem der vorhergehenden Ansprüche, wobei das Wechselstromsignal (60) ein Sinussignal ist, und/oder wobei das Wechselstromsignal (60) eine Frequenz von 3 bis 10 Hz aufweist.

**8.** Verfahren nach einem der vorhergehenden Ansprüche, wobei das Überlagern des Wechselstromsignals (60) erfolgt, in dem das Wechselstromsignal über wenigstens einen Entkopplungskondensator (44a, 44b, 44c) in das Gleichstromsystem (10) ein- und ausgekoppelt wird.

**9.** Verfahren nach einem der vorhergehenden Ansprüche, weiter umfassend:

Einkoppeln des Wechselstromsignals über einen Transformator (42).

**10.** Verfahren nach einem der vorhergehenden Ansprüche, wobei die Amplitude (U) des Wechselstromsignals weniger als 150 V beträgt.

**11.** Vorrichtung (22) zum Ermitteln des Erdwiderstands eines Gleichstromsystems (10), welches ein nicht definiertes Potential zur Erde aufweist, die Vorrichtung umfassend:

einen Wechselstromgenerator (28) zum Erzeugen eines Wechselstromsignals; eine Kopplungsanordnung (24) zum Ein- und Auskoppeln des Wechselstromsignals in einen Gleichstromkreis (12) des Gleichstromsystems,

eine Messanordung (26) zum Ermitteln der Stromstärke (64) und der Spannung (62) des Wechselstromsignals (60), eine Verarbeitungseinheit (30), die dazu ausgeführt ist, einen Erdwiderstand des Gleichstromsystems (10) aus der Stromstärke und der Spannung des Wechselstromsignals zu ermitteln.

**12.** Gleichstromsystem (10), insbesondere Elektrolysesystem, mit einer Vorrichtung (22) zum Ermitteln des Erdwiderstands des Gleichstromsystems nach Anspruch 11.

**13.** Programmelement, das, wenn es auf einem Prozessor ausgeführt wird, den Prozessor anleitet, die Schritte des Verfahrens nach einem der Ansprüche 1 bis 10 durchzuführen.

**14.** Computerlesbares Medium, auf dem ein Programmelement nach Anspruch 13 gespeichert ist.

Fig. 1

EP 2 450 715 A1

42    24                16

⊕

18

44b

44c

46

52                20    20

Fig. 2

S10

S12

S14

S16

S18

Fig. 3

Fig. 4

Fig. 5

Europäisches
Patentamt

European
Patent Office

Office européen
des brevets

**EUROPÄISCHER RECHERCHENBERICHT**

Nummer der Anmeldung

EP 10 19 0359

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 913 697 A2 (MATSUSHITA ELECTRIC IND CO LTD [JP] PANASONIC CORP [JP]) 6. Mai 1999 (1999-05-06) * Zusammenfassung; Ansprüche 1,6; Abbildungen 1,4,5,12,13,16 * * Absatz [0002] - Absatz [0010] * * Absatz [0025] - Absatz [0049] * ----- | 1-14 | INV. G01R27/18 G01R31/02 |
| E | EP 2 256 506 A1 (BENDER W GMBH CO KG [DE]) 1. Dezember 2010 (2010-12-01) * Zusammenfassung; Abbildung 1 * * Absatz [0036] * ----- | 1-14 | |
| A | US 4 638 245 A (MACPHEE COLIN A A [CA] ET AL) 20. Januar 1987 (1987-01-20) * Zusammenfassung; Abbildung 2 * * Spalte 1, Zeile 5 - Spalte 2, Zeile 3 * ----- | 1-14 | |
| A | EP 0 751 396 A1 (FIAT AUTO SPA [IT]) 2. Januar 1997 (1997-01-02) * Zusammenfassung; Abbildungen 1-3 * ----- | 1-14 | RECHERCHIERTE SACHGEBIETE (IPC) G01R |

Der vorliegende Recherchenbericht wurde für alle Patentansprüche erstellt

| Recherchenort | Abschlußdatum der Recherche | Prüfer |
|---|---|---|
| Berlin | 4. Mai 2011 | Ernst, Monika |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 10 19 0359

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-05-2011

| Im Recherchenbericht angeführtes Patentdokument | | Datum der Veröffentlichung | Mitglied(er) der Patentfamilie | | Datum der Veröffentlichung |
|---|---|---|---|---|---|
| EP 0913697 | A2 | 06-05-1999 | CN | 1216826 A | 19-05-1999 |
| | | | KR | 19990037526 A | 25-05-1999 |
| | | | TW | 403838 B | 01-09-2000 |
| | | | US | 6320389 B1 | 20-11-2001 |
| EP 2256506 | A1 | 01-12-2010 | WO | 2010136284 A1 | 02-12-2010 |
| US 4638245 | A | 20-01-1987 | CA | 1219634 A1 | 24-03-1987 |
| EP 0751396 | A1 | 02-01-1997 | DE | 69624409 D1 | 28-11-2002 |
| | | | DE | 69624409 T2 | 14-08-2003 |
| | | | ES | 2185726 T3 | 01-05-2003 |
| | | | IT | TO950536 A1 | 27-12-1996 |

EPO FORM P0461

Für nähere Einzelheiten zu diesem Anhang : siehe Amtsblatt des Europäischen Patentamts, Nr.12/82